# EUROPEAN PATENT SPECIFICATION

(11) **EP 3 185 258 B1**
(45) Date of publication and mention of the grant of the patent: **06.11.2019**
(21) Application number: 15846668.0
(22) Date of filing: 28.09.2015
(51) Int. Cl.: H01F 17/06, H01F 27/02, H01F 27/06, H01F 27/29, H05K 9/00, H01F 3/14, H01F 27/28, H01F 27/32

(54) **OUTPUT NOISE REDUCTION DEVICE**
VORRICHTUNG ZUR AUSGANGSRAUSCHUNTERDRÜCKUNG
DISPOSITIF DE RÉDUCTION DU BRUIT DE SORTIE

(30) Priority: 30.09.2014 JP 2014202083
(43) Date of publication of application: 28.06.2017
(73) Proprietor: Kitagawa Industries Co., Ltd., Inazawa-shi, Aichi 492-8446 (JP)
(72) Inventor: TANIMIZU, Tomokazu, Inazawa-shi Aichi 492-8446 (JP); UENO, Kazushige, Inazawa-shi Aichi 492-8446 (JP); MORITA, Katsuyuki, Inazawa-shi Aichi 492-8446 (JP)
(74) Representative: Prüfer & Partner mbB Patentanwälte · Rechtsanwälte
(86) International application number: PCT/JP2015/077262
(87) International publication number: WO 2016/052378

(56) References cited:
- JP-A- 2005 093 536
- JP-A- 2012 095 030
- JP-A- 2012 160 522
- JP-A- 2014 030 331
- JP-A- 2014 116 539
- JP-U- S49 114 434
- JP-U- S51 113 132
- US-A1- 2014 240 946

## Description

### FIELD

A technique disclosed in the present application relates to an output-noise reduction device that reduces noise mixed in output voltage and the like flowing in a conducting bar, and particularly relates to a structure for fixing an output terminal of a conducting bar.

### BACKGROUND

Conventionally, there has been a risk that switching noise at operation frequency of an electronic device and the like as well as its harmonic frequency could be mixed in output voltage and an output signal output from a switching power supply and other electronic devices via a conducting bar. Such switching noise might negatively affect supplying devices such as an external electronic device, and thus needs to be reduced as appropriate. The switching power supply outputs output voltage of a predetermined voltage value through a switching operation of a power transistor. When the power transistor is turned ON and OFF, the current path is switched, and this might generate noise at a switching frequency and its harmonic frequency depending on a rated output. The noise is superimposed on the output voltage to be transmitted to the supplying device via the conducting bar and negatively affects the supplying device. Thus, a device for reducing such noise needs to be provided. In one known output-noise reduction device, a conducting bar is inserted to a magnetic body core to form a noise filter for removing the noise flowing in the conducting bar (see, for example, JP 2005-93536 A).
JP 2014 030331 A discloses a bus bar assembly including a core having a hollow part, a bus bar inserted into the hollow part and resin filled in a gap between the core and the bus bar.

### SUMMARY

An output terminal such as a bolt, to be connected to the connection terminal of the supplying device, is attached to the above-described conducting bar. For example, the bolt is preferably fixed to the conducting bar in the following manner in terms of downsizing the device. Specifically, the bolt is disposed on a center axis of the conducting bar having a cylindrical shape, so that the two members are colinearly fixed. In this type of output-noise reduction device, to protect the conducting bar and the magnetic body core, the conducting bar and the like may be encapsulated by a resin material such as epoxy resin for example. For example, when the bolt is colinearly fixed to the cylindrical conducting bar, a resin material or the like encapsulating the conducting bar fails to function as the resistance against the movement of the conducting bar in the axial direction. Thus, the relative movement between the resin and the conducting bar cannot be restricted. Thus, when force in a detaching direction acts in the state where the output terminal (bolt) is fixed to the connection terminal of the supplying device, separation of the output terminal and the conducting bar from the encapsulating resin might occur.

The technique disclosed in the present application is made in view of the problem described above, and an object of the present application is to provide an output-noise reduction device that can achieve more effective fixing of an output terminal.

### MEANS FOR SOLVING THE PROBLEM

The above mentioned problem of the present invention is solved by the output-noise reduction device according to claim 1 or 3. An output-noise reduction device according to a technique disclosed in the present application outputs an output signal output from an electronic device to a supplying device with noise mixed in the output signal reduced, and includes a magnetic body core, a conducting bar, an encapsulating member, and an output terminal. The magnetic body core has a through hole. The conducting bar functions as a line through which the output signal or the like is transmitted from the electronic device to the supplying device. The conducting bar is inserted in the magnetic body core, has one end portion in an inserting direction serving as a connecting portion to be connected to the electronic device, and has another end portion provided with a bent portion bent to be in an orthogonal direction with respect to the inserting direction. The encapsulating member encapsulates the magnetic body core and the conducting bar inserted to the magnetic body core. The output terminal is fixed to the bent portion of the conducting bar and is connected to the supplying device. In the output-noise reduction device, the bent portion orthogonal to the inserting direction serves as a portion providing resistance against the encapsulating member with respect to movement of the conducting bar in the inserting direction. Thus, when the force in the detaching direction (the inserting direction of the conducting bar) is applied in a state where the output terminal is fixed to a connection terminal of the supplying device, movement of the conducting bar in the inserting direction with respect to the encapsulating member can be prevented, with the bent portion serving as a resistance against the encapsulating member. Thus, the movement can be restricted. In the output-noise reduction device, the output terminal, such as a bolt, can be fixed to the bent portion, bent toward the orthogonal direction with respect to the inserting direction, by press fitting, welding, caulking, or the like for example. Thus, the output terminal can be more rigidly fixed to the conducting bar. Thus, the output terminal can be favorably fixed to the conducting bar despite the force in the inserting and removing direction acting when the output terminal is attached to the connection terminal of the supplying device by screwing or detached from the connection terminal.

The output terminal is fixed to the bent portion bent from the end portion of the conducting bar. The output terminal and the main body portion of the conducting bar are positioned while being shifted from each other in the orthogonal direction with respect to the inserting direction. Thus, for example, when the force in the inserting and removing direction acts on the output terminal that has been attached to the supplying device, the applied force is transmitted to the main body portion of the conducting bar via the bent portion. All things considered, the force acting on the output terminal is dispersed at the bent portion and then is transmitted to the conducting bar, whereby the output-noise reduction device as a whole can be prevented from detaching from the electronic device.

In the output-noise reduction device of the present application, the bent portion may have a shape of a flat plate and have a surface facing the supplying device exposed from the encapsulating member to be connected to the connection terminal of the supplying device. In the output-noise reduction device, the end surface of the bent portion exposed from the encapsulating member is directly electrically connected to the connection terminal of the supplying device. Generally, a metal material (such as copper) used for the conducting bar has a higher conductivity than a metal material (such as chrome molybdenum steel or carbon steel) used for the output terminal that is needed to have higher strength as a fastening member fastened to the supplying device. Thus, the output-noise reduction device can achieve lower power consumption, with an electrical resistance on a line through which the output signal or the like is transmitted, with the conducting bar connected to the electronic device directly connected to the supplying device.

In the output-noise reduction device of the present application, the bent portion may include a curved portion formed by being curved by a predetermined angle from the one end portion of the conducting bar in the inserting direction toward the orthogonal direction with respect to the inserting direction. Thus, the force in the inserting direction acting on the output terminal, due to the attachment or the like to the supplying device, is transmitted to the main body portion of the conducting bar after being relaxed at the curved portion. Thus, the output-noise reduction device as a whole can be prevented from detaching from the electronic device.

In the output-noise reduction device of the present application, the bent portion is provided with a press fitting hole in which the output terminal is press fit, and the output terminal includes: an output terminal portion extending in the inserting direction; a latching portion having a flat plate shape that is formed on a base end portion of the output terminal portion and expands from a center axis of the output terminal portion in an orthogonal direction with respect to the center axis; and a step portion that is formed on a distal end surface of the latching portion and is fit and fixed in the press fitting hole in the bent portion. With this configuration, the step portion is fit in the press fitting hole, whereby the output terminal can be more effectively fixed to the bent portion.

In the output-noise reduction device of the present application, the bent portion is provided with a press fitting hole in which the output terminal is press fit, the output terminal includes: a bolt to be connected to the supplying device; and a nut, in which the bolt is fastened by screwing, the nut being provided with a press fitting portion formed to have a size corresponding to a size of the press fitting hole, and the bolt is fastened to the nut, fixed with the press fitting portion fit in the press fitting hole, by screwing. With this configuration, the bolt is fastened to the nut, fixed with the press fitting portion fit in the press fitting hole, whereby the output terminal can be more effectively fixed to the bent portion.

### EFFECT OF THE INVENTION

With an output-noise reduction device according to a technique disclosed in the present application, an output terminal can be more effectively fixed.

### BRIEF DESCRIPTION OF DRAWINGS

[Fig. 1] Fig. 1 is a circuit diagram illustrating a configuration in which a noise filter module as an example of an output-noise reduction device according to an embodiment is connected to a switching power supply.
[Fig. 2] Fig. 2 is an exploded perspective view of the noise filter module according to the embodiment.
[Fig. 3] Fig. 3 is a perspective view illustrating a state of the noise filter module in an embodiment as a result of primary molding.
[Fig. 4] Fig. 4 is a perspective view illustrating a state of the noise filter module in the embodiment as a result of secondary molding.
[Fig. 5] Fig. 5 is a schematic cross-sectional view of a bolt fixed to a bent portion.
[Fig. 6] Fig. 6 is a schematic cross-sectional view of a bolt fixed to a bent portion according to another embodiment.

### DESCRIPTION OF EMBODIMENTS

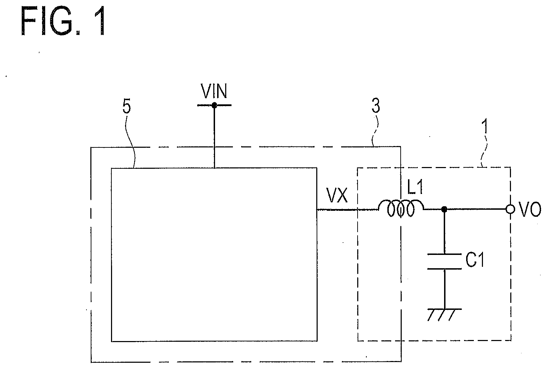

One embodiment of the present invention is described with reference to the drawings. Fig. 1 is a circuit diagram illustrating a noise filter module 1, as one example of an output-noise reduction device according to the present application, in a state where the noise filter module 1 is connected between an output terminal VX of a switching power supply 5 and an output terminal VO. The switching power supply 5 is accommodated in a metal casing 3 made by aluminum die casting and the like. For example, the switching power supply 5 is an on-vehicle power supply and is a step-down switching power supply that steps down a voltage value of driving power supply voltage VIN supplied from an in battery (not illustrated) in a hybrid vehicle, an electric vehicle, or the like, and supplies resultant power to an auxiliary battery (not illustrated). The auxiliary battery supplies power supply voltage to on-vehicle electronic devices such as an audio device, an air conditioner device, and a lighting device.

The switching power supply 5 performs ON/OFF control on a power transistor (not illustrated) at a predetermined switching frequency f to obtain an output of predetermined voltage. In the switching power supply 5, a current path is switched with the power transistor turned ON and OFF in accordance with such a switching operation, whereby alternate voltage fluctuation occurs between high voltage and low voltage at the switching frequency f. In the switching power supply 5, current, corresponding to load current, alternately and thus intermittently flows from the power supply voltage VIN and to ground potential GND, whereby current fluctuation occurs. Thus, in the switching power supply 5, the voltage fluctuation and the current fluctuation due to the switching operation might be a cause of switching noise at the switching frequency f and its harmonic frequency. For example, such switching noise might be transmitted to the output terminal VX as conductive noise, transmitted in a circumventing manner through a signal path and ground wiring, and inductive noise, transmitted through a space due to electromagnetic coupling such as capacitive coupling.

In the switching power supply 5 according to the present embodiment, the noise filter module 1 is connected to the output terminal VX. The noise filter module 1 has what is known as an LC filter structure with a choke coil L1 provided in an output voltage path connecting between the output terminal VX of the switching power supply 5 and the output terminal VO, and a capacitor C1 connected between the output terminal VO and the ground potential GND. The switching frequency f in the switching power supply 5 depends on the rated output power and specifications of components. For example, some switching power supplies installed in vehicles are operated at several hundred kHz. In such a case, the switching frequency f and its harmonic frequency might overlap with frequency band of an on-vehicle AM radio receiver, and the noise filter module 1 can reduce noise transmitted on the signal path in such a band.

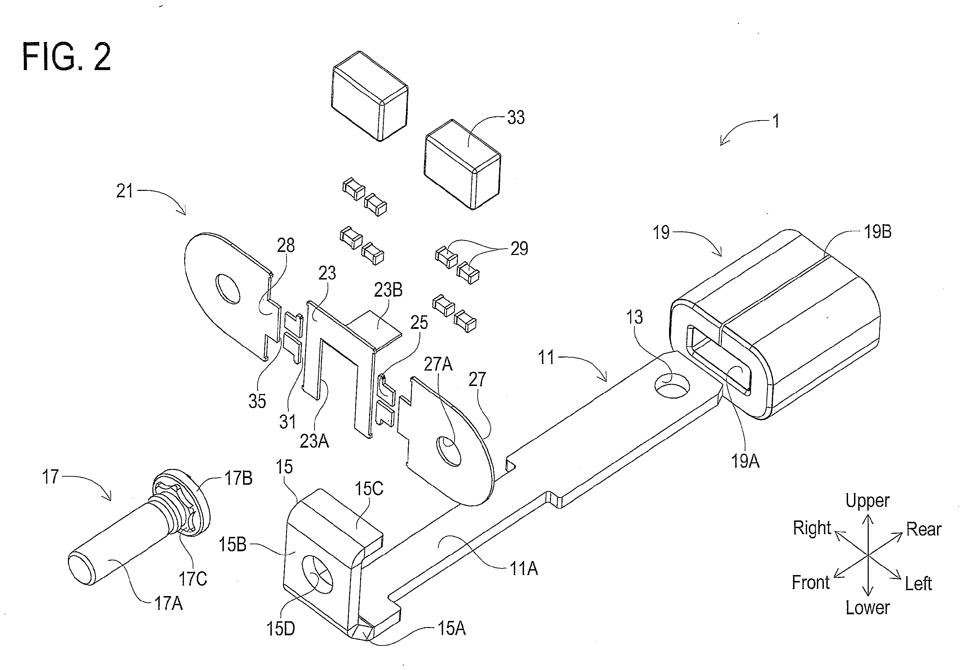

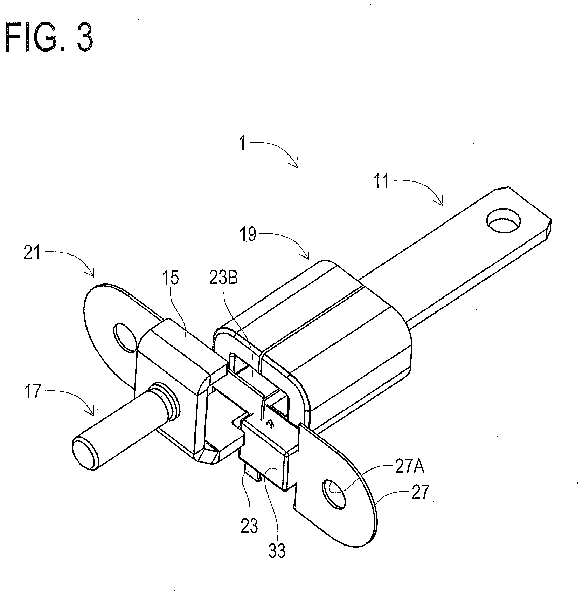

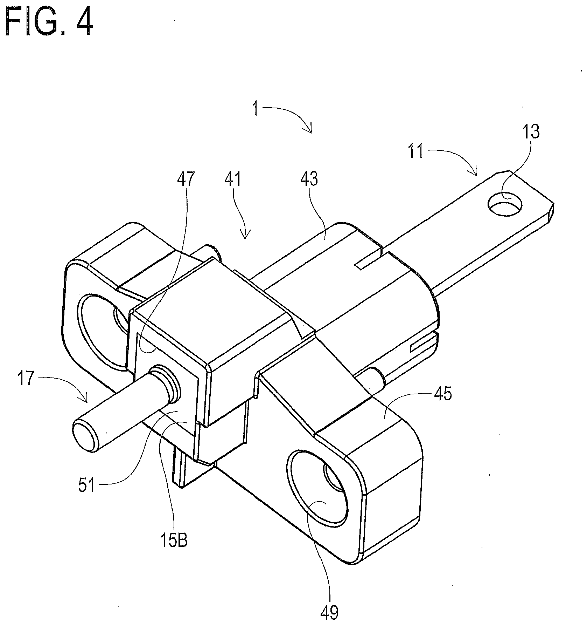

Next, a shape/structure of the noise filter module 1 will be described. Fig. 2 is an exploded perspective view of the noise filter module 1. Fig. 3 is a perspective view of the noise filter module 1 in a state as a result of primary molding. Fig. 4 is a perspective view of the noise filter module 1 in a state as a result of secondary molding.

As illustrated in Fig. 2, the noise filter module 1 includes a conducting bar 11, a bolt 17, a magnetic body core 19, a lead frame 21, and the like. The output voltage path, connecting between the output terminal VX of the switching power supply 5 and the output terminal VO illustrated in Fig. 1, mainly includes the conducting bar 11 illustrated in Fig. 2. The conducting bar 11 is formed to have a rectangular plate shape elongated in a single direction. The following description is given with a longitudinal direction of the conducting bar 11 defined as a front and rear direction, a direction orthogonal to a flat plate portion of the conducting bar 11 defined as an upper and lower direction, and a direction orthogonal to the front and rear direction and to the upper and lower direction defined as a left and right direction, as illustrated in Fig. 2. The conducting bar 11 is formed to have a substantially rectangular shape extending in the front and rear direction, as viewed from above.

For example, the conducting bar 11 is made of a metal material such as copper or aluminum. The conducting bar 11 has an end portion on a rear side (right side in Fig. 2) provided with a connection hole 13 formed through the upper and lower direction. The conducting bar 11 has the connection hole 13 connected to the output terminal VX of the switching power supply 5 disposed in the metal casing 3 illustrated in Fig. 1.

The conducting bar 11 has a bent portion 15 that is on a front side (left side in Fig. 2) and has a distal end portion bent toward the above. The bent portion 15 includes a first curved portion 15A, a bolt connecting portion 15B, and a second curved portion 15C. The first curved portion 15A continues from the distal end portion of the conducting bar 11, and is curved upward by a predetermined angle. The bolt connecting portion 15B continues from a distal end portion of the first curved portion 15A, and has planes in parallel with the upper and lower direction and the left and right direction. The bolt connecting portion 15B has a center portion provided with an insertion hole 15D formed through the front and rear direction, and the bolt 17 is fixed in the insertion hole 15D. The second curved portion 15C continues from the upper end portion of the bolt connecting portion 15B and is bent rearward by a predetermined angle.

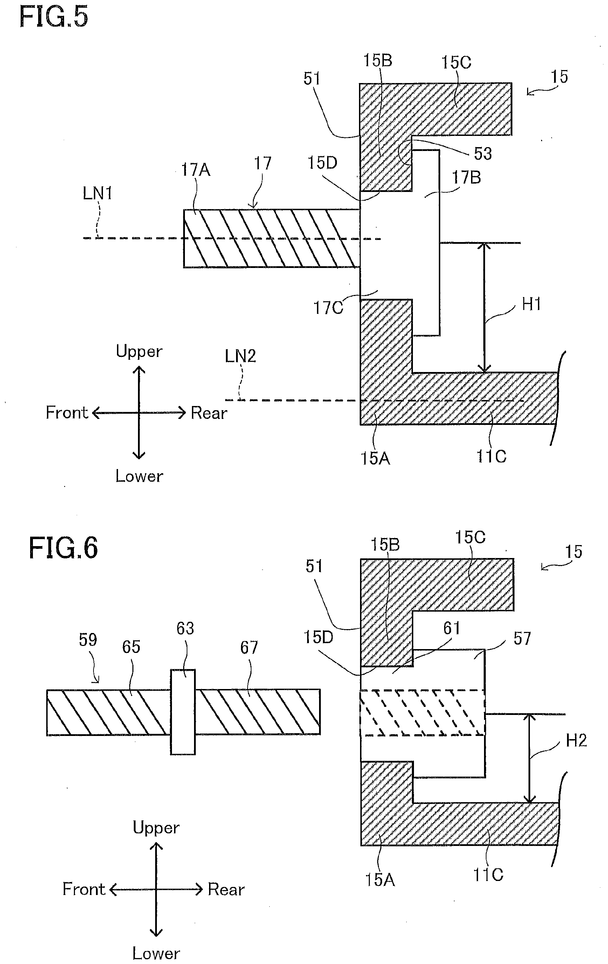

The bolt 17 includes an output terminal portion 17A and a latching portion 17B. The output terminal portion 17A has a circular column shape extending in the front and rear direction, and has an outer circumference surface provided with a male screw (see Fig. 5) used for fixing to a connection terminal of the auxiliary battery and the like through screwing. In the bolt 17, the latching portion 17B is integrally formed with a rear end surface of the output terminal portion 17A. The latching portion 17B expands in the radial direction from a center axis LN1 (see Fig. 5) of the output terminal portion 17A extending along the front and rear direction, to have a disk shape with a larger diameter than the output terminal portion 17A. Thus, the circular latching portion 17B has the center positioned on the center axis LN1 of the output terminal portion 17A having the circular column shape.

The latching portion 17B has a surface 53 (see Fig. 5) on the front side (on the side of the output terminal portion 17A) provided with a step portion 17C as a step in the axial direction of the latching portion 17B. The step portion 17C expands to be in a substantially star shape surrounding the output terminal portion 17A, as viewed from the front. The bolt 17 is press fit into the insertion hole 15D in a direction from the rear side of the bolt connecting portion 15B toward the front, and is fixed with the step portion 17C fit in the insertion hole 15D.

The magnetic body core 19 includes a hollow portion 19A formed through the front and rear direction, and thus has a hollow cylindrical shape. For example, the magnetic body core 19 is made of a magnetic material such as ferrite. The magnetic body core 19 has an ellipsoidal shape expanding in the left and right direction, as viewed in the front and rear direction. Thus, the hollow portion 19A has the ellipsoidal shape expanding in the left and right direction as viewed in the front and rear direction, to have a larger width than the conducting bar 11 in the left and right direction, whereby the conducting bar 11 can be inserted.

The conducting bar 11 includes a core attachment portion 11A with a smaller width in the left and right direction than the width of a portion where the connection hole 13 is formed. The core attachment portion 11A has a uniform width in the left and right direction, in a section from substantially the center portion of the conducting bar 11 in the front and rear direction to the vicinity of the front end portion. The choke coil L1 (see Fig. 1) is formed with the conducting bar 11 inserted in the hollow portion 19A of the magnetic body core 19 in such a manner that the inner side surface of the hollow portion 19A faces the core attachment portion 11A of the conducting bar 11.

The magnetic body core 19 has a slit 19B as a notch, in the upper and lower direction, on an upper side one (on the upper side in Fig. 2) of portions opposed to each other in the upper and lower direction. The slit 19B serves as what is known as a core gap, and extends in the front and rear direction while passing through the center portion of the magnetic body core 19 in the left and right direction. With the slit 19B, a partially discontinuous magnetic path is achieved in the circumference direction of the magnetic body core 19. The magnetic resistance of the magnetic body core 19 can be adjusted by changing the width and the like of the slit 19B, so that the magnetic saturation can be prevented from occurring. In the noise filter module 1, the inductance of the choke coil L1 needed for removing the noise component can be ensured with the magnetic saturation thus prevented by adjusting the width of the slit 19B of the magnetic body core 19.

The lead frame 21 includes a first fixing portion 23, connecting portions 25, and second fixing portions 27. The lead frame 21 is made of a highly conductive metal material (such as brass or copper for example). The first fixing portion 23 includes: a notch portion 23A formed by partially notching a substantially square plate shape member; and a joint portion 23B formed by bending the notched portion. The joint portion 23B is bent rearward to a position where the plane of the notched portion is orthogonal to the upper and lower direction. The joint portion 23B has a rectangular shape as viewed in the upper and lower direction. The notch portion 23A is formed in such a manner that opening is formed at the center of a lower end portion. Thus, the first fixing portion 23 has a substantially upside-down U shape with a lower side open as viewed in the front and rear direction. As illustrated in Fig. 3, the lead frame 21 is fixed to the conducting bar 11, with the lower surface of the joint portion 23B fixed to the upper surface of the core attachment portion 11A by welding or the like, in a state where the core attachment portion 11A is inserted in the notch portion 23A of the first fixing portion 23. The lead frame 21 is electrically connected to the conducting bar 11 via the joint portion 23B. The conducting bar 11 has a front end portion of the core attachment portion 11A attached to the lead frame 21 and has a rear side attached to the magnetic body core 19.

The connecting portions 25 couple between the first fixing portion 23 and the second fixing portions 27, when chip capacitors 29 are mounted thereon. The connecting portions 25 according to the present embodiment are formed as a pair of pieces that are opposed to each other in the upper and lower direction and are disposed on each of left and right sides of the first fixing portion 23. The chip capacitors 29 are mounted on an end portion of each connecting portion 25 on the inner side in the left and right direction and a corresponding one of end portions of the first fixing portion 23 on the outer side in the left and right direction, with a slit 31 provided between the end portions. Similarly, the chip capacitors 29 are mounted on an end portion of each connecting portion 25 on the outer side in the left and right direction and an end portion of the corresponding second fixing portion 27 on the inner side, with a slit 35 provided between the end portions.

Thus, the four chip capacitors 29 are mounted between each of the second fixing portions 27, opposing each other in the left and right direction, and the first fixing portion 23. The four chip capacitors 29 are two pairs of two chip capacitors 29, connected in series, mounted in parallel. The bent portion 15 and the bolt 17 form the output terminal VO (see Fig. 1). The ground potential GND is supplied to the second fixing portions 27 via a fastening member (such as a bolt) fastened to the metal casing 3 for the switching power supply 5 described later by screwing. Thus, the chip capacitors 29 form the capacitor C1 (Fig. 1).

The second fixing portions 27 are each formed to have a plate shape with a plane orthogonal to the front and rear direction, and each have an end portion on the inner side in the left and right direction provided with a protruding portion 28 protruding inward, and the chip capacitors 29 are mounted on the protruding portion 28. The second fixing portions 27 each have an arch-shaped end portion on the outer side in the left and right direction. The second fixing portions 27 each have a fixing hole 27A into which an unillustrated bolt or the like is inserted into in the front and rear direction to fix a secondary molded member 41 (see Fig. 4) of the encapsulated noise filter module 1 to the metal casing 3. The second fixing portions 27 are each fixed with the fastening member, such as the bolt inserted in the fixing hole 27A, fastened to an attachment portion of the metal casing 3.

For example, the lead frame 21 can be formed through the following steps. First of all, a flat metal plate is punched by a punching process and the like, whereby members that are supposed to be the first fixing portion 23, the connecting portions 25, and the second fixing portions 27 are formed in a state of being bridged by thin metal wires. Then, the chip capacitors 29 are mounted by soldering and the like. Next, parts of the first fixing portion 23 and the second fixing portions 27, as well as the chip capacitors 29 and the connecting portion 25 are encapsulated with an insulating material such as a resin material, whereby a primary molded member 33 is formed. The resin material used for the primary molded member 33 includes phenol resin, epoxy resin, unsaturated polyester, and the like. The parts of the first fixing portion 23 and the second fixing portions 27, as well as the chip capacitors 29 and the connecting portions 25 have their relative positions fixed with the primary molded member 33 thus formed. Then, the bridging portions of the thin metal wires are cut, whereby the lead frame 21 illustrated in Fig. 3 is formed.

Fig. 4 illustrates the secondary molded member 41 obtained by further encapsulating the noise filter module 1 with thermoset resin, after the primary molded member 33 illustrated in Fig. 3 is formed. The secondary molded member 41 includes: a core molded member 43 that entirely encapsulates an outer circumference surface of the magnetic body core 19; and a frame molded member 45 that entirely encapsulates the lead frame 21 with the primary molded member 33 formed, by insert molding for example. Thus, a resin material applying no excessive pressure to the magnetic body core 19 such as phenol resin, epoxy resin, or unsaturated polyester is used as the thermoset resin used for forming the secondary molded member 41.

The bolt 17 protrudes from a front side end surface of the frame molded member 45, and an opening 47 from which a front side end surface 51 of the bolt connecting portion 15B provided in the bent portion 15 is exposed is formed in the frame molded member 45. Fixing holes 49 are formed through the frame molded member 45 in the front and rear direction, at positions corresponding to the fixing holes 27A (see Fig. 2) of the second fixing portion 27, and fastening members such as bolts are inserted in the fixing holes 49. In each of the fixing holes 49, a bolt or the like is fastened while being in direct contact with an exposed part of the corresponding second fixing portions 27. Thus, each of the fixing holes 49 has an inner diameter defining an opening size large enough not to cause contact and interference between the inner circumference surface of the fixing hole 49 and the bolt and the like for the fastening. For example, the metal casing 3 (see Fig. 1) is provided with a protruding portion protruding forward at a position corresponding to the fixing hole 49, and the attachment portion where the bolt or the like is fastened is formed at the protruding portion. In the noise filter module 1, the protruding portion of the metal casing 3 is inserted in the fixing hole 49 of the secondary molded member 41 from the rear side, and the bolt inserted from the front side is fastened for fixing, in a state where the protruding portion is in close contact with the second fixing portions 27 exposed from the fixing hole 49.

Fig. 5 is a schematic cross-sectional view of the bolt 17 fixed to the bent portion 15. The bolt 17 is press fit into the insertion hole 15D from the rear side to the front side of the bolt connecting portion 15B. The step portion 17C is fixed by being fit while having a part plastically deformed and having an outer circumference surface in contact with an inner circumference of the insertion hole 15D. In a state where the bolt 17 is fixed to the bent portion 15, the latching portion 17B is fixed with the front side surface 53 being in close contact with the bolt connecting portion 15B. The output terminal portion 17A of the bolt 17 and the end surface 51 of the bolt connecting portion 15B, exposed from the above-described secondary molded member 41 (see Fig. 4), serve as the output terminal VO to be connected to a connection terminal of a supplying device on a subsequent stage.

As illustrated in Fig. 5, the center axis LN1 of the bolt 17 having a cylindrical shape and an axis LN2 along the front and rear direction in which a main body portion 11C of the conducting bar 11 extends are at positions shifted from each other in the upper and lower direction. Thus, for example, force in a detaching direction (rear direction) acting on the bolt 17 after the supplying device has been attached is transmitted to the main body portion 11C of the conducting bar 11 via the bent portion 15. Thus, the force acting on the bolt 17 is transmitted to the main body portion 11C after being dispersed by the bent portion 15, whereby the noise filter module 1 as a whole can be prevented from detaching from the electronic device.

The noise filter module 1 is an example of the output-noise reduction device. The switching power supply 5 is an example of the electronic device. The output voltage is an example of the output signal. The auxiliary battery and the on-vehicle electronic devices, such as an audio device, an air conditioning device, and a lighting device, receiving power supply voltage from the auxiliary battery are each an example of the supplying device. A terminal on the side of the connection hole 13 of the conducting bar 11 is an example of the connecting portion. The insertion hole 15D is an example of the press fitting hole. The bolt 17 is an example of the output terminal. The hollow portion 19A is an example of the through hole in the magnetic body core 19. The front and rear direction is an example of the insertion direction in which the conducting bar 11 is inserted into the magnetic body core 19. The chip capacitors 29 are an example of the capacitive element. The secondary molded member 41 is an example of the encapsulating member.

As described in detail above, in the noise filter module 1 according to the embodiment described above disclosed in the present application, the conducting bar 11 has the front end portion provided with the bent portion 15 bent upward to be orthogonal with the front and rear direction. The bolt 17 is fixed to the insertion hole 15D provided to the bent portion 15 of the conducting bar 11, and is connected to the supplying device such as an auxiliary battery. In the noise filter module 1, the bent portion 15 orthogonal to the front and rear direction serves as the resistance against the secondary molded member 41 with respect to movement of the conducting bar 11 in the front and rear direction. Thus, when the force in the detaching direction (the front and rear direction) is applied in a state where the bolt 17 is fixed to the connection terminal of the supplying device, movement of the conducting bar 11 in the front and rear direction with respect to the frame molded member 45 can be prevented, with the bent portion 15 serving as the resistance against the frame molded member 45. In the noise filter module 1, the bolt 17 can be fixed to the bent portion 15 by press fitting, whereby the bolt 17 can be more tightly fixed to the conducting bar 11. Thus, the bolt 17 can be favorably fixed to the conducting bar 11 despite the force in the inserting and removing direction acting when the bolt 17 is attached to the connection terminal of the supplying device by screwing.

The bolt connecting portion 15B of the bent portion 15 has a shape of a flat plate, with the front side (supplying device side) end surface 51, as one of the two facing surfaces in the front and rear direction, exposing from the opening 47 of the frame molded member 45 to be connected to the connection terminal of the supplying device. Thus, the noise filter module 1 has a part (end surface 51) of the conducting bar 11 directly and electrically connected to the connection terminal of the supplying device. Generally, a metal material (such as copper) used for the conducting bar 11 has a higher conductivity than a metal material (such as chrome molybdenum steel or carbon steel) used for the bolt 17 that is needed to have higher strength. Thus, the noise filter module 1 can achieve lower power consumption, with an electrical resistance on a line through which the output voltage is transmitted from the electronic device to the supplying device reduced.

The bent portion 15 has the first curved portion 15A formed to be curved upward by a predetermined angle from the front end portion of the conducting bar 11. Thus, the force in the front and rear direction acting on the bolt 17, due to the attachment or the like to the supplying device, is transmitted to the main body portion 11C of the conducting bar 11 after being relaxed at the first curved portion 15A. Thus, the noise filter module 1 as a whole can be prevented from detaching from the electronic device.

The bolt 17 has the latching portion 17B having a disk shape formed on the base end portion of the output terminal portion 17A having a cylindrical shape. The latching portion 17B has a distal end (front side) surface 53 provided with the step portion 17C. The bolt 17 is press fit to the insertion hole 15D of the bent portion 15, and can be more effectively fixed to the bent portion 15 with the step portion 17C fit in the insertion hole 15D.

It is a matter of course that the technique disclosed in the present application is not limited to the embodiments described above, and can be modified and changed in various ways without departing from the gist of the present application.

For example, the configuration of the bolt 17 according to the embodiment is merely an example, and can be changed as appropriate. The configuration of a bolt illustrated in Fig. 6 may be alternatively employed. Specifically, a bolt 59 may be fixed to the nut 57 fixed to the insertion hole 15D by screwing. In Fig. 6, configurations that are the same or a similar to the counterparts in Fig. 5 are denoted with the same reference numerals, and the description thereof is omitted as appropriate. The nut 57 illustrated in Fig. 6 has a substantially cylindrical shape, and has a press fitting portion 61, corresponding to the size of the insertion hole 15D of the bolt connecting portion 15B, protruding from the front end portion. The nut 57 is fixed such that the center axis of the cylindrical shape extending along the front and rear direction with the press fitting portion 61 press fit to the insertion hole 15D from the rear side of the bolt connecting portion 15B.

The bolt 59 has a substantially cylindrical shape elongated in the front and rear direction. More specifically, what is known as a stud bolt shape with screw portions 65 and 67 formed on the front and rear sides of a disk portion 63 with a larger outer diameter than diameters of other portions. The screw portion 65 on the front side is formed as a male screw to be fastened to the connection terminal of the supplying device by screwing. The screw portion 67 on the rear side is formed as a male screw to be fastened to the nut 57 by screwing. The bolt 59 is fixed to the nut 57 fixed to the insertion hole 15D, with the screw portion 67 screwed from the front side by screwing. The bolt 59 is fastened until the disk portion 63 comes into contact with the press fitting portion 61. Also in this configuration, the bolt 59 can be more effectively fixed to the bolt connecting portion 15B, as in the configuration described above with reference to Fig. 5 where the bolt 17 is directly press fit.

The nut 57 has a longer length in the front and rear direction than the latching portion 17B of the bolt 17 illustrated in Fig. 5. Thus, detaching can be prevented even when the length in the radial direction (the upper and lower direction) is shorter than that of the latching portion 17B. Thus, the height H2, as the distance from the main body portion 11C of the nut 57, can be made shorter than the height HI from the main body portion 11C of the latching portion 17B illustrated in Fig. 5. In this configuration, the bent portion 15 can be downsized with the length of the bolt connecting portion 15B in the upper and lower direction set to be shorter, and thus the noise filter module 1 can be downsized. In this configuration, the distance (height H2) from the main body portion 11C is short, whereby the rotational moment acting on the bolt 59 about the base end portion (the portion to be connected to the first curved portion 15A) of the bolt connecting portion 15B can be reduced. All things considered, the configuration can achieve more effective fixing of the bolt 59 to the bolt connecting portion 15B.

In the embodiment described above, the bolt 17 is fixed to the insertion hole 15D of the bent portion 15 by pressing fitting. However, the method of fixing to the bent portion 15 of the bolt 17 is not limited to this, and another fixing method (such as caulking or welding) may be employed.

In the embodiment described above, the output terminal as the bolt 17 on which a male screw is formed is described as an example. The output terminal according to the present application is not limited to the bolt 17, and may be a member obtained by processing a different conductive material that is fastened with a method other than screwing.

In the above-described embodiment, the thermoset resin is used as the resin material for encapsulating the primary molded member 33 and the secondary molded member 41. However, this is not to be construed in a limiting sense. For example, thermoset resin such as Polyphenylene Sulfide (PPS) and Polybutylene Terephthalate (PBT) may also be used.

In the above-described embodiment, the slit 19B formed on the magnetic body core 19 for preventing the magnetic saturation from occurring, may be omitted depending on the physical configuration and the like of the magnetic body core 19.

### EXPLANATION OF REFERENCE NUMERALS

1 noise filter module
5 switching power supply
11 conducting bar
13 connection hole
15 bent portion
17 bolt
19 magnetic body core
19A hollow portion
23 first fixing portion
27 second fixing portion
27A fixing hole
29 chip capacitors
21 lead frame
41 molded member
45 frame molded member

## Claims

1. An output-noise reduction device (1) that outputs an output signal from an electronic device (5) to a supplying device such as an external electronic device and reduces a noise generated by the electronic device and mixed in the output signal, the output-noise reduction device comprising:
a magnetic body core (19) that is made of a magnetic material and has a through hole (19A);
a conducting bar (11) that is made of a conductive material, inserted in the through hole in the magnetic body core, has one end portion in an inserting direction serving as a connecting portion to be connected to the electronic device, and has another end portion provided with a bent portion (15) bent to be in an orthogonal direction with respect to the inserting direction;
an encapsulating member (41) that is made of a resin material, and encapsulates the magnetic body core and the conducting bar inserted to the magnetic body core; and
an output terminal (VO) that is fixed to the bent portion of the conducting bar and is configured to be connected to the supplying device such as an external electronic device, wherein
the bent portion includes a first curved portion (15A) formed by being curved by a predetermined angle from the one end portion of the conducting bar in the inserting direction toward the orthogonal direction with respect to the inserting direction, and a bolt connecting portion (15B) continuing from a distal end portion of the first curved portion,
the bolt connecting portion is provided with a press fitting hole (15D) in which the output terminal is press fit,
the output terminal includes:
a bolt (59) to be connected to the supplying device such as an external electronic device; and
a nut (57), in which the bolt is fastened by screwing, the nut being provided with a press fitting portion (61) formed to have a size corresponding to a size of the press fitting hole, and
the bolt is fastened to the nut, fixed with the press fitting portion fit in the press fitting hole, by screwing, **characterized in that**
the output-noise reduction device further comprises a capacitor (29) being connected to the output terminal and being adapted for connection to ground potential, the capacitor being encapsulated by the encapsulating member;
the bent portion includes a second curved portion (15C) continuing from an end portion of the bolt connecting portion and formed by being bent by a predetermined angle from the end portion of the bolt connecting portion toward the one end portion in the inserting direction.

2. The output-noise reduction device according to claim 1, wherein the bent portion has a shape of a flat plate and has a surface (51) facing the supplying device such as an external electronic device exposed from the encapsulating member to be connected to the connection terminal of the supplying device such as an external electronic device.

3. An output-noise reduction device (1) that outputs an output signal from an electronic device (5) to a supplying device such as an external electronic device and reduces a noise generated by the electronic device and mixed in the output signal, the output-noise reduction device comprising:
a magnetic body core (19) that is made of a magnetic material and has a through hole (19A);
a conducting bar (11) that is made of a conductive material, inserted in the through hole in the magnetic body core, has one end portion in an inserting direction serving as a connecting portion to be connected to the electronic device, and has another end portion provided with a bent portion (15) bent to be in an orthogonal direction with respect to the inserting direction;
an encapsulating member (41) that is made of a resin material, and encapsulates the magnetic body core and the conducting bar inserted to the magnetic body core; and
an output terminal (VO) that is fixed to the bent portion of the conducting bar and is configured to be connected to the supplying device such as an external electronic device, wherein
the bent portion includes a first curved portion (15A) formed by being curved by a predetermined angle from the one end portion of the conducting bar in the inserting direction toward the orthogonal direction with respect to the inserting direction, and a bolt connecting portion (15B) continuing from a distal end portion of the first curved portion
the bolt connecting portion is provided with a press fitting hole (15D) in which the output terminal is press fit, and
the output terminal includes:
an output terminal portion (17A) extending in the inserting direction;
a latching portion (17B) having a flat plate shape that is formed on a base end portion of the output terminal portion and expands from a center axis of the output terminal portion in an orthogonal direction with respect to the center axis; and
a step portion (17C) that is formed on a distal end surface of the latching portion and is fit and fixed in the press fitting hole in the bent portion, **characterized in that**
the output-noise reduction device further comprises a capacitor (29) being connected to the output terminal and being adapted for connection to ground potential, the capacitor being encapsulated by the encapsulating member;
the bent portion includes a second curved portion (15C) continuing from an end portion of the bolt connecting portion and formed by being bent by a predetermined angle from the end portion of the bolt connecting portion toward the one end portion in the inserting direction.

4. The output-noise reduction device according to claim 3, wherein the bent portion has a shape of a flat plate and has a surface (51) facing the supplying device such as an external electronic device exposed from the encapsulating member to be connected to the connection terminal of the supplying device such as an external electronic device.

## Patentansprüche

1. Eine Vorrichtung (1) zur Ausgangsrauschunterdrückung, die ein Ausgangssignal aus einer elektronischen Vorrichtung (5) an eine Zuführvorrichtung wie etwa eine externe elektronische Vorrichtung ausgibt, und die ein durch die elektronische Vorrichtung erzeugtes und in dem Ausgangssignal gemischtes Rauschen reduziert, wobei die Vorrichtung zur Ausgangsrauschunterdrückung umfasst:
einen magnetischen Körperkern (19), der aus einem magnetischen Material gebildet ist und ein Durchgangsloch (19A) besitzt;
einen leitfähigen Stab (11), der aus einem leitfähigen Material gebildet ist, in dem Durchgangsloch im magnetischen Körperkern eingesetzt ist, einen Endabschnitt in einer Einsetzrichtung besitzt, der als ein mit der elektronischen Vorrichtung zu verbindender Verbindungsabschnitt dient, und der einen anderen Endabschnitt besitzt, der mit einem gebogenen Abschnitt (15) versehen ist, der in einer zu der Einsetzrichtung senkrechten Richtung gebogen ist;
ein Vergusselement (41), das aus einem Harzmaterial hergestellt ist, und dass den magnetischen Körperkern und den in dem magnetischen Körperkern eingesetzten leitfähigen Stab einkapselt; und
einen Ausgangsanschluss (VO), der an dem gebogenen Abschnitt des leitfähigen Stabs befestigt und eingerichtet ist, mit der Zuführvorrichtung wie etwa eine externe elektronische Vorrichtung verbunden zu werden, wobei
der gebogene Abschnitt einen ersten gekrümmten Abschnitt (15A), der gebildet ist, indem er um einen vorbestimmten Winkel von dem einen Endabschnitt des leitfähigen Stabs in der Einsetzrichtung hin zu einer in Bezug auf die Einsetzrichtung senkrechten Richtung gekrümmt wird, und ferner einen Bolzenverbindungabschnitt (15B) aufweist, der sich von einem distalen Endabschnitt des ersten gekrümmten Abschnitts fortsetzt,
wobei der Bolzenverbindungabschnitt mit einem Presssitzloch (15D) versehen ist, in welchem der Ausgangsanschluss press-eingepasst ist,
wobei der Ausgangsanschluss aufweist:
einen Bolzen (59), der mit der Zuführvorrichtung wie etwa eine externe elektronische Vorrichtung zu verbinden ist; und
eine Mutter (57), in welcher der Bolzen durch Schrauben befestigt wird, wobei die Mutter mit einem Presspassabschnitt (61) versehen ist, der in einer Größe ausgebildet ist, die einer Größe des Presssitzlochs entspricht, und
wobei der Bolzen an der Mutter, durch den Presspassabschnitt in dem Presssitzloch fixiert, durch Schrauben befestigt wird, **dadurch gekennzeichnet, dass**
die Vorrichtung zur Ausgangsrauschunterdrückung einen Kondensator (29) aufweist, der mit dem Ausgangsanschluss verbunden ist und zur Verbindung mit Grundpotenzial angepasst ist, und wobei der Kondensator von dem Vergusselement eingekapselt ist;
und wobei der gebogene Abschnitt einen zweiten gekrümmten Abschnitt (15C) aufweist, der sich von einem Endabschnitt des Bolzenverbindungsabschnitts fortsetzt und gebildet ist, indem er um einen vorbestimmten Winkel von dem Endabschnitt des Bolzenverbindungabschnitts hin zu dem einen Endabschnitt in der Einsetzrichtung gebogen ist.

2. Die Vorrichtung zur Ausgangsrauschunterdrückung gemäß Anspruch 1, wobei der gebogene Abschnitt die Form einer flachen Platte besitzt und eine Oberfläche (51) aufweist, die der Zuführvorrichtung wie etwa eine externe elektronische Vorrichtung zugewandt ist, und die von dem Vergusselement freigelegt ist, um mit dem Verbindungsanschluss der Zuführvorrichtung wie etwa eine externe elektronische Vorrichtung verbunden zu werden.

3. Eine Vorrichtung (1) zur Ausgangsrauschunterdrückung, die ein Ausgangssignal aus einer elektronischen Vorrichtung (5) an eine Zuführvorrichtung wie etwa eine externe elektronische Vorrichtung ausgibt, und die ein durch die elektronische Vorrichtung erzeugtes und in dem Ausgangssignal gemischtes Rauschen reduziert, wobei die Vorrichtung zur Ausgangsrauschunterdrückung umfasst:
einen magnetischen Körperkern (19), der aus einem magnetischen Material gebildet ist und ein Durchgangsloch (19A) besitzt;
einen leitfähigen Stab (11), der aus einem leitfähigen Material gebildet ist, in dem Durchgangsloch im magnetischen Körperkern eingesetzt ist, einen Endabschnitt in einer Einsetzrichtung besitzt, der als ein mit der elektronischen Vorrichtung zu verbindender Verbindungsabschnitt dient, und der einen anderen Endabschnitt besitzt, der mit einem gebogenen Abschnitt (15) versehen ist, der in einer zu der Einsetzrichtung senkrechten Richtung gebogen ist;
ein Vergusselement (41), das aus einem Harzmaterial hergestellt ist, und dass den magnetischen Körperkern und den in dem magnetischen Körperkern eingesetzten leitfähigen Stab einkapselt; und
einen Ausgangsanschluss (VO), der an dem gebogenen Abschnitt des leitfähigen Stabs befestigt und eingerichtet ist, mit der Zuführvorrichtung wie etwa eine externe elektronische Vorrichtung verbunden zu werden, wobei
der gebogene Abschnitt einen ersten gekrümmten Abschnitt (15A), der gebildet ist, indem er um einen vorbestimmten Winkel von dem einen Endabschnitt des leitfähigen Stabs in der Einsetzrichtung hin zu einer in Bezug auf die Einsetzrichtung senkrechten Richtung gekrümmt wird, und ferner einen Bolzenverbindungabschnitt (15B) aufweist, der sich von einem distalen Endabschnitt des ersten gekrümmten Abschnitts fortsetzt,
wobei der Bolzenverbindungabschnitt mit einem Presssitzloch (15D) versehen ist, in welchem der Ausgangsanschluss press-eingepasst ist,
wobei der Ausgangsanschluss aufweist:
einen Ausgangsanschlussabschnitt (17A), der sich in einer Einsetzrichtung erstreckt;
einen Rastabschnitt (17B) mit der Form einer flachen Platte, der auf einem Basisendabschnitt des Ausgangsanschlussabschnitts ausgebildet ist und sich von einer Mittenachse des Ausgangsanschlussabschnitts in einer zu der Mittenachse senkrechten Richtung erstreckt; und
einem Stufenabschnitt (17C), der auf einer distalen Endoberfläche des Rastabschnitts ausgebildet ist, und der in dem Presssitzloch im gebogenen Abschnitt eingepasst und fixiert ist, **dadurch gekennzeichnet, dass**
die Vorrichtung zur Ausgangsrauschunterdrückung ferner einen Kondensator (29) umfasst, der mit dem Ausgangsanschluss verbunden ist und zur Verbindung mit Grundpotenzial angepasst ist, und wobei der Kondensator von dem Vergusselement eingekapselt ist;
und wobei der gebogene Abschnitt einen zweiten gekrümmten Abschnitt (15C) aufweist, der sich von einem Endabschnitt des Bolzenverbindungsabschnitts fortsetzt und gebildet ist, indem er um einen vorbestimmten Winkel von dem Endabschnitt des Bolzenverbindungabschnitts hin zu dem einen Endabschnitt in der Einsetzrichtung gebogen ist.

4. Die Vorrichtung zur Ausgangsrauschunterdrückung gemäß Anspruch 1, wobei der gebogene Abschnitt die Form einer flachen Platte besitzt und eine Oberfläche (51) aufweist, die der Zuführvorrichtung wie etwa eine externe elektronische Vorrichtung zugewandt ist, und die von dem Vergusselement freigelegt ist, um mit dem Verbindungsanschluss der Zuführvorrichtung wie etwa eine externe elektronische Vorrichtung verbunden zu werden.

## Revendications

1. Dispositif de réduction du bruit de sortie (1) qui délivre en sortie un signal de sortie d'un dispositif électronique (5) vers un dispositif de distribution tel qu'un dispositif électronique externe et réduit un bruit généré par le dispositif électronique et mélangé dans le signal de sortie, le dispositif de réduction du bruit de sortie comprenant :
un noyau de corps magnétique (19) qui est constitué d'un matériau magnétique et qui possède un trou traversant (19A) ;
une barre conductrice (11) qui est constituée d'un matériau conducteur, insérée dans le trou traversant dans le noyau de corps magnétique, possède une partie d'extrémité dans une direction d'insertion servant de partie de connexion pour être connectée au dispositif électronique et possède une autre partie d'extrémité munie d'une partie courbée (15) qui est courbée pour être dans une direction orthogonale par rapport à la direction d'insertion ;
un élément d'encapsulation (41) qui est constitué d'un matériau de résine et encapsule le noyau de corps magnétique et la barre conductrice insérée dans le noyau de corps magnétique ; et
une borne de sortie (VO) qui est fixée à la partie courbée de la barre conductrice et est configurée pour être connectée au dispositif de distribution tel qu'un dispositif électronique externe, dans lequel
la partie courbée inclut une première partie incurvée (15A) formée en étant incurvée d'un angle prédéterminé par rapport à ladite une partie d'extrémité de la barre conductrice dans la direction d'insertion vers la direction orthogonale par rapport à la direction d'insertion, et une partie de connexion de boulon (15B) se prolongeant à partir d'une partie d'extrémité distale de la première partie incurvée,
la partie de connexion de boulon est munie d'un trou d'ajustement par pression (15D) dans lequel la borne de sortie est ajustée par pression,
la borne de sortie inclut :
un boulon (59) à connecter au dispositif de distribution tel qu'un dispositif électronique externe ; et
un écrou (57), dans lequel le boulon est fixé par vissage, l'écrou étant muni d'une partie d'ajustement par pression (61) formée pour avoir une taille correspondant à une taille du trou d'ajustement par pression, et
le boulon est fixé à l'écrou, fixé avec la partie d'ajustement par pression ajustée dans le trou d'ajustement par pression, par vissage, **caractérisé en ce que**
le dispositif de réduction du bruit de sortie comprend en outre un condensateur (29) connecté à la borne de sortie et adapté pour une connexion à un potentiel de masse, le condensateur étant encapsulé par l'élément d'encapsulation ;
la partie courbée inclut une seconde partie incurvée (15C) se prolongeant à partir d'une partie d'extrémité de la partie de connexion de boulon et formée en étant courbée d'un angle prédéterminé par rapport à la partie d'extrémité de la partie de connexion de boulon vers ladite une première partie d'extrémité dans la direction d'insertion.

2. Dispositif de réduction du bruit de sortie selon la revendication 1, dans lequel la partie courbée possède une forme d'une plaque plate et possède une surface (51) faisant face au dispositif de distribution tel qu'un dispositif électronique externe, exposée à partir de l'élément d'encapsulation pour être connectée à la borne de connexion du dispositif de distribution tel qu'un dispositif électronique externe.

3. Dispositif de réduction du bruit de sortie (1) qui délivre en sortie un signal de sortie d'un dispositif électronique (5) vers un dispositif de distribution tel qu'un dispositif électronique externe et réduit un bruit généré par le dispositif électronique et mélangé dans le signal de sortie, le dispositif de réduction du bruit de sortie comprenant :
un noyau de corps magnétique (19) qui est constitué d'un matériau magnétique et qui possède un trou traversant (19A) ;
une barre conductrice (11) qui est constituée d'un matériau conducteur, insérée dans le trou traversant dans le noyau de corps magnétique, possède une partie d'extrémité dans une direction d'insertion servant de partie de connexion pour être connectée au dispositif électronique et possède une autre partie d'extrémité munie d'une partie courbée (15) qui est courbée pour être dans une direction orthogonale par rapport à la direction d'insertion ;
un élément d'encapsulation (41) qui est constitué d'un matériau de résine et encapsule le noyau de corps magnétique et la barre conductrice insérée dans le noyau de corps magnétique ; et
une borne de sortie (VO) qui est fixée à la partie courbée de la barre conductrice et est configurée pour être connectée au dispositif de distribution tel qu'un dispositif électronique externe, dans lequel
la partie courbée inclut une première partie incurvée (15A) formée en étant incurvée d'un angle prédéterminé par rapport à ladite une partie d'extrémité de la barre conductrice dans la direction d'insertion vers la direction orthogonale par rapport à la direction d'insertion, et une partie de connexion de boulon (15B) se prolongeant à partir d'une partie d'extrémité distale de la première partie incurvée
la partie de connexion de boulon est munie d'un trou d'ajustement par pression (15D) dans lequel la borne de sortie est ajustée par pression, et
la borne de sortie inclut :
une partie de borne de sortie (17A) s'étendant dans la direction d'insertion ;
une partie de verrouillage (17B) ayant une forme de plaque plate qui est formée sur une partie d'extrémité de base de la partie de borne de sortie et s'élargit à partir d'un axe central de la partie de borne de sortie dans une direction orthogonale par rapport à l'axe central ; et
une partie de palier (17C) qui est formée sur une surface d'extrémité distale de la partie de verrouillage et est ajustée et fixée dans le trou d'ajustement par pression de la partie courbée, **caractérisé en ce que**
le dispositif de réduction du bruit de sortie comprend en outre un condensateur (29) connecté à la borne de sortie et adapté pour une connexion à un potentiel de masse, le condensateur étant encapsulé par l'élément d'encapsulation ;
la partie courbée inclut une seconde partie incurvée (15C) se prolongeant à partir d'une partie d'extrémité de la partie de connexion de boulon et formée en étant courbée d'un angle prédéterminé par rapport à la partie d'extrémité de la partie de connexion de boulon vers ladite une première partie d'extrémité dans la direction d'insertion.

4. Dispositif de réduction du bruit de sortie selon la revendication 3, dans lequel la partie courbée possède une forme de plaque plate et possède une surface (51) faisant face au dispositif de distribution tel qu'un dispositif électronique externe, exposée à partir de l'élément d'encapsulation pour être connectée à la borne de connexion du dispositif de distribution tel qu'un dispositif électronique externe.
